# EUROPEAN PATENT SPECIFICATION

(11) **EP 1 801 263 B1**
(45) Date of publication and mention of the grant of the patent: **27.03.2013**
(21) Application number: 06256430.7
(22) Date of filing: 19.12.2006
(51) Int. Cl.: C23C 28/02, C23C 4/08

(54) **Platinum modified NiCoCrAly bondcoat for thermal barrier coating**
Platinmodifizierte NiCoCrAly-Bindeschicht für eine Wärmedämmbeschichtung
Couche de liaison de NiCoCrAly modifié par le platine pour revêtement de barrière thermique

(30) Priority: 21.12.2005 US 315535
(43) Date of publication of application: 27.06.2007
(73) Proprietor: United Technologies Corporation, Hartford, CT 06101 (US)
(72) Inventor: Kasule, Asumini, New Britain, CT 06053 (US)
(74) Representative: Leckey, David Herbert

(56) References cited:
- EP-A1- 0 587 341
- EP-A1- 0 825 271
- EP-A2- 0 902 104
- JP-A- 6 306 640
- US-A- 4 321 311
- US-A- 4 477 538
- US-A- 6 123 997
- US-A1- 2005 123 783

## Description

The present invention relates to a platinum modified NiCoCrAlY bondcoat for a thermal barrier coating and a method for forming the same.

Turbine engine components are subjected to elevated temperatures as a result of their exposure to high temperature gas. Such exposure can lead to the creation of unwanted defects in the components. To ,protect the components, bondcoats and/or ceramic topcoats are applied to the surfaces of the turbine engine components.

US 4,321,322, for example, discloses a thermal barrier coating consisting of a metallic layer of MCrAlY alloy, a continuous adherent alumina layer on the metallic layer and a discontinuous ceramic layer on the alumina layer. An interlayer of platinum may also be deposited between the superalloy substrate and the MCrAlY layer.

US 4,477,538 discloses a coating for nickel/cobalt base alloy comprising a platinum metal underlayer, an intermediate MCrAlY layer, and a platinum metal overlayer.

Despite the existence of such coatings, there is still a need for coatings which provide the components with improved oxidation resistance.

Accordingly, the present invention is directed to an improved coating system for a turbine engine component and methods for forming the same.

In accordance with an aspect of the present invention, there is provided a method for forming a coating on a substrate as claimed in claim 1.

In accordance with another aspect of the present invention, there is provided a turbine engine component as claimed in claim 15.

Various embodiments of the platinum modified NiCoCrAlY bondcoat for a thermal barrier coating of the present invention, as well as other advantages attendant thereto, are set forth in the following description and the accompanying drawings wherein like reference numerals depict like elements.
FIG. 1 is a schematic representation of a first coating system in accordance with an embodiment of the present invention; and
FIG. 2 is a schematic representation of a second coating system, but which does not fall within the scope of the claims.

As discussed, the present invention is directed to an improved coating system that can be applied to turbine engine components, such as vanes, blades, and seals, that are exposed to high temperature gases. The coating system includes a thin bondcoat that offers oxidation protection to the nickel based superalloy forming the turbine engine component. The bondcoat is a platinum modified NiCoCrAlY coating. The addition of the platinum to the bondcoat improves the adherence of the aluminum oxide scale that forms during use of the turbine engine component.

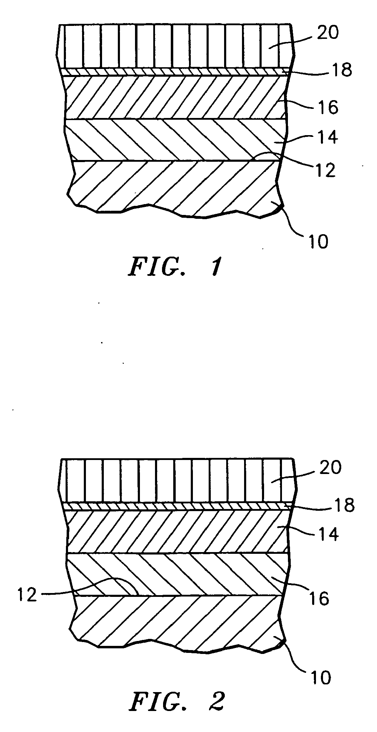

FIG. 1 illustrates a first sequence for forming a coating system in accordance with an embodiment of the present invention. As shown therein, a nickel based alloy substrate 10 has a surface 12. A layer 14 of platinum is deposited onto the surface 12, preferably using an electroplating technique. For purposes of illustration only, a useful electroplating bath may contain platinum quantities in the range of 17 to 26 grams/liter. The current density may range from 20 to 30 amps per square foot. The time for electroplating will be determined by the required thickness. The electroplating bath temperature can go up to 200 degrees F (93°C). The layer of electroplated platinum may have a thickness in the range of from about 0.01 to 1.0 mil (0.00025 mm - 0.025 mm). These electroplating parameters are offered merely for purposes of illustration as other platinum electroplating parameters can be employed. The platinum layer also can be deposited by techniques other than electroplating, such as including, but not limited to sputtering, and other deposition techniques.

Thereafter, a layer 16 of NiCoCrAlY material is deposited onto the platinum layer. Preferably, the NiCoCrAlY material is deposited using a cathodic arc deposition process. Techniques for applying the coatings of the present invention by cathodic arc plasma vapor deposition are discussed in U.S. Patent Nos. 5,972,185; 5,932,078; 6,036,828; 5,792,267; and 6,224,726. Alternate methods of deposition including, but not limited to, other plasma vapor deposition techniques such as magnetron sputtering and electron beam plasma vapor deposition may be used. When thickness concerns are not present, various thermal spray techniques such as low pressure plasma spray and HVOF (high velocity oxy-fuel) techniques may be utilized. The NiCoCrAlY material which is deposited may have a composition comprising from about 4.0 to 25 wt%, preferably from about 4.0 to 18 wt%, chromium, from about 2.0 to 28 wt%, preferably from about 2.0 to 24 wt%, cobalt, from about 5.5 to 15 wt%, preferably from about 5.5 to 13.5 wt%, aluminum, from about 0.1 to 1.6 wt%, preferably from about 0.1 to 0.8 wt%, yttrium, up to about 2.0 wt%, preferably from about 0.001 to 0.4 wt%, hafnium, up to about 2.0 wt%, preferably from about 0.001 to 0.7 wt%, silicon, from about 3.0 to 12 wt%, preferably from about 3.0 to 10 wt%, tantalum, from about 1.0 to 12 wt%, preferably from about 1.0 to 9.0 wt% tungsten, from 1.0 to 10 wt%, preferably from about 1.0 to 5.0 wt% rhenium, up to 2.0 wt%, preferably from 0.001 to 1.0 wt%, zirconium, up to 4.0 wt%, preferably from about 0.001 to 2.0 wt%, niobium, up to about 4.0 wt%, preferably from about 0.001 to 2.0 wt%, titanium, from about 0.2 to 6.0 wt%, preferably from about 0.2 to 4.0 wt%, molybdenum, and the balance nickel. The coating may also comprise up to 2.0 wt% of other elements as impurities. The yttrium in the coating improves the adherence of the aluminum oxide scale layer 18 which is formed during use. Sulfur would usually migrate to the aluminum oxide scale layer 18; however, the presence of yttrium prevents this from occurring.

Following deposition of the NiCoCrAlY material, the substrate 10 with the deposited layers 14 and 16 is subjected to a diffusion heat treatment. The diffusion heat treatment is carried out at a temperature in the range of from about 1200 to about 2100 degrees Fahrenheit (649-1149°C) for a time period in the range of from about 2.0 to 15 hours. The diffusion treatment is carried out in an inert gas atmosphere such as an argon atmosphere. The fully heat treated platinum modified NiCoCrAlY bondcoat may a platinum content in the range of from 5.0 to 70 wt%, preferably from 10 to 60 wt%, and may have a thickness in the range of from about 1.0 to 5.0 mils (0.025-0.127 mm). The bondcoat forms a dense three-dimensional interconnected two-phase microstructure with grains sizes ranging from 0.5 to 30 µm.

Once the bondcoat is formed, a ceramic topcoat 20 may be applied using any suitable ceramic composition known in the art. A preferred composition for the ceramic topcoat 20 is yttria stabilized zirconia such as 7.0 wt% yttria stabilized zirconia. Other favored compositions include zirconia based pyrochlores, 5.0 to 60 mol% gadolinia stabilized zirconia, and zirconia stabilized with various lanthanide sesquioxides and mixtures thereof described in U.S. Patent No. 6,730,422. The ceramic topcoat layer 20 may have a thickness in the range of from about 1.0 to 50 mils (0.025-1.27 mm), preferably from about 3.0 to 15 mils (0.076-0.381 mm) .

The ceramic topcoat 20 may be applied using any suitable electron beam-physical vapor deposition (EB-PVD) technique known in the art. A preferred deposition technique is electron beam physical vapor deposition (EB-PVD). Ceramic coatings are preferably applied to bondcoated substrates at substrate temperature ranging from about 1700 to 2200 degrees Fahrenheit (927-1204°C), and chamber pressures from about 0.1 to 1.0 millitorr. Deposition time ranges from 20 to 120 minutes using feedstock federates of from about 0.2 to 1.5 inches (5.1-38.1 mm) per hour. Other suitable deposition techniques include thermal spraying, chemical vapor deposition, and other physical vapor deposition techniques including, but not limited to, cathodic arc deposition, sputtering, and thermal evaporation. Either an inert or reactive atmosphere can optionally be used in these deposition techniques, as known to be appropriate to one skilled in the art.

When produced by vapor deposition techniques, the ceramic topcoat layer 20 is characterized by a columnar grained microstructure with the columnar grains or columns being oriented substantially perpendicular to the surface 12. The columnar grains or columns extend outwardly from the bondcoat or from an aluminum oxide scale layer, 18 that is intentionally formed on the bondcoat before or during deposition of the ceramic layer 20. In addition, vapor deposition techniques that utilize means to increase the mobility of vapor species on the substrate surface, such as substrate bias or high-energy ion impingement, result in dense equiaxed ceramic coatings. Alternatively, thermally sprayed coatings that form by depositing liquid droplets on the substrate have a porous microstructure consisting of randomly piled frozen splats of liquid. These splats are typically microcracked and typically trap pores between them, resulting in a strain-tolerant microstructure.

Referring now to FIG. 2, there is shown an alternative sequence for forming a coating system, but which does not fall within scope of the claims. In this method, the bondcoat is formed by depositing the NiCoCrAlY layer 16 onto the surface 12 of the substrate and then depositing the platinum layer 14 over the NiCoCrAlY layer 16. The NiCoCrAlY layer may have the same composition as described above and may be deposited using the technique described above. The platinum layer 14 may have the same compositional range as described above and may be deposited using the electroplating technique described above. The diffusion heat treatment step is performed after the platinum depositing step using the same parameters as described above. The preferred bondcoat thickness is the same as that discussed in the prior method. The ceramic topcoat layer 20 may be deposited as discussed above.

Specimens coated in accordance with the present invention have survived greater than 1000 hours of cyclic oxidation in a burner rig at temperatures in excess of 2000 degrees Fahrenheit (1093°C).

## Claims

1. A method for forming a coating on a substrate (10) comprising the steps of:
providing a substrate (10);
depositing a layer (14) of platinum onto a surface (12) of said substrate (10); and
depositing a NiCoCrAIY layer (16) onto said platinum layer;
**characterised by** the step of:
heat treating said substrate (10) with said deposited layers (14, 16) at a temperature in the range of from about 1200 to about 2100 degrees Fahrenheit (649°C-1149°C) for a time period in the range of from about 2.0 to 15 hours in an inert gas atmosphere so as to form a platinum modified NiCoCrAIY bondcoat having a three-dimensional interconnected two-phase microstructure with grain sizes from 0.5 to 30 µm, wherein said platinum in said bondcoat is present in an amount from about 5.0 to 70 wt%.

2. The method according to claim 1, wherein said substrate providing step comprises providing a substrate (10) formed from a nickel based alloy and wherein said platinum layer (14) depositing step comprises electroplating said platinum layer (14) on said substrate surface (12).

3. The method according to claim 1 or 2, wherein said platinum depositing step comprises depositing a layer (14) of platinum having a thickness in the range of from 0.01 to 1.0 mil (0.00025-0.025 mm).

4. The method according to any preceding claim, wherein said platinum in said bondcoat is present in an amount from about 10 to 60 wt%.

5. The method according to any preceding claim, wherein said NiCoCrAIY depositing step comprises depositing said NiCoCrAly layer (16) using a cathodic arc deposition process.

6. The method according to any preceding claim, wherein said NiCoCrAIY depositing step comprises depositing NiCoCrAIY material comprising from about 4.0 to 25 wt% chromium, from about 2.0 to 28 wt% cobalt, from about 5.5 to 15 wt% aluminium, from about 0.1 to 1.6 wt% yttrium, up to about 2.0 wt% hafnium, up to about 2.0 wt% silicon, from about 3.0 to 12 wt% tantalum, from about 1.0 to 12 wt% tungsten, from about 1.0 to 10 wt% rhenium, up to about 2.0 wt% zirconium, up to about 4.0 wt% niobium, up to about 4.0 wt% titanium, from about 0.2 to 6.0 wt% molybdenum, and the balance nickel.

7. The method according to any of claims 1 to 5, wherein said NiCoCrAIY depositing step comprises depositing a NiCoCrAlY material comprising from about 4.0 to 18 wt% chromium, from about 2.0 to 24 wt% cobalt, from about 5.5 to 13.5 wt% aluminium, from about 0.1 to 0.8 wt% yttrium, from about 0.001 to 0.4 wt% hafnium, from about 0.001 to 0.7 wt% silicon, from about 3.0 to 10 wt% tantalum, from about 1.0 to 9.0 wt% tungsten, from about 1.0 to 5.0 wt% rhenium, from about 0.001 to 1.0 wt% zirconium, from about 0.001 to 2.0 wt% niobium, from about 0.001 to 2.0 wt% titanium, from about 0.2 to 4.0 wt% molybdenum, and the balance nickel.

8. The method according to any preceding claim, wherein said inert gas atmosphere in which said substrate (10) is heat treated is an argon atmosphere.

9. The method according to any preceding claim, further comprising applying a ceramic topcoat over said bondcoat having a thickness in the range of from about 1.0 to 50 mils (0,025-1.27 mm).

10. The method according to any of claims 1 to 8, further comprising applying a ceramic topcoat (20) over said bondcoat having a thickness in the range of from about 3.0 to 15 mils (0.076-0.381 mm).

11. The method according to claim 9 or 10, wherein said ceramic topcoat applying step comprises applying a yttria stabilized zirconia topcoat (20).

12. The method according to claim 9 or 10, wherein said ceramic topcoat applying step comprises applying a zirconia based pyrochlore topcoat (20).

13. The method according to claim 9 or 10, wherein said ceramic topcoat applying step comprises applying a 5.0 to 60 mol% gadolinia stabilized zirconia.

14. The method according to any of claims 9 to 13, wherein said ceramic topcoat applying step comprises applying said topcoat (20) using an EB-PVD technique and thereby forming said topcoat (20) with a columnar grained microstructure wherein columnar grains are oriented substantially perpendicular to said substrate surface (12) and extend outwardly from the bondcoat.

15. A turbine engine component comprising:
a substrate (10) formed from a nickel based superalloy; and
a platinum modified NiCoCrAIY bondcoat applied to a surface (12) of said substrate (10) having a three-dimension interconnected two-phase microstructure with grain sizes from 0.5 to 30 µm and containing from about 5.0 to 70 wt% platinum formed by the method of any of claims 1 to 8.

16. A turbine engine component according to claim 15, wherein said bondcoat has a thickness in the range of from 1.0 to 5.0 mils (0.025-0.127 mm).

17. A turbine engine component according to claim 15 or 16, further comprising a ceramic topcoat (20) and a layer (18) of aluminium oxide scale between said ceramic topcoat (20) and said bondcoat, whereby said bondcoat improves adherence of said aluminium oxide scale (18).

18. A turbine engine component according to claim 17, wherein said ceramic topcoat (20) comprises a yttria stabilized zirconia.

19. A turbine engine component according to claim 17, wherein said ceramic topcoat (20) comprises a zirconia based pyrochlore topcoat.

20. A turbine engine component according to claim 17, wherein said ceramic topcoat (20) comprises a 5 to 60 mol% gadolinia stabilized zirconia.

21. A turbine engine component according to any of claims 17 to 20, wherein said ceramic topcoat (20) has a thickness in the range of from 1.0 to 50 mils (0.025-1.27 mm) and a columnar grained microstructure with columnar grains oriented substantially perpendicular to the surface (12) of the substrate (10) extending outwardly from the bondcoat and alumina scale (18).

22. A turbine engine component according to claim 21, wherein said thickness is in the range of from 3.0 to 15 mils (0.076-0.381 mm).

23. A turbine engine component according to any of claims 15 to 22, wherein said bondcoat contains from about 10 to about 60 wt% platinum.

## Patentansprüche

1. Verfahren zur Herstellung einer Beschichtung auf einem Substrat (10), folgende Schritte aufweisend:
Bereitstellen eines Substrats (10);
Abscheiden einer Schicht (14) aus Platin auf einer Oberfläche (12) des Substrats (10); und
Abscheiden einer NiCoCrAIY-Schicht (16) auf der Platinschicht;
**gekennzeichnet durch** den Schritt des:
Wärmebehandelns des Substrats (10) mit den abgeschiedenen Schichten (14, 16) bei einer Temperatur in dem Bereich von etwa 1200 bis etwa 2100 Grad Fahrenheit (649° C-1149° C) für eine Zeitdauer in dem Bereich von etwa 2,0 bis 15 Stunden in einer Inertgas-Atmosphäre, um eine platinmodifizierte NiCoCrAIY-Bindungsschicht mit einer dreidimensional ineinandergreifenden Zwei-Phasen-Mikrostruktur mit Korngrößen von 0,5 bis 30 µm zu bilden, wobei das Platin in der Bindungsschicht in einer Menge von etwa 6,0 bis 70 Gewichtsprozent vorliegt.

2. Verfahren nach Anspruch 1, wobei der Schritt des Bereitstellens des Substrats ein Bereitstellen eines Substrats (10), das aus einer Legierung auf Nickelbasis hergestellt ist, aufweist, und wobei der Schritt des Abscheidens der Platinschicht (14) ein Elektroplattieren der Platinschicht (14) auf der Substratoberfläche (12) aufweist.

3. Verfahren nach Anspruch 1 oder 2, wobei der Schritt des Abscheidens von Platin ein Abscheiden einer Schicht (14) aus Platin mit einer Dicke in dem Bereich von 0,01 bis 1,0 mil (0,00025-0,025 mm) aufweist.

4. Verfahren nach einem vorangehenden Anspruch, wobei das Platin in der Bindungsschicht in einer Menge von etwa 10 bis 60 Gewichtsprozent vorliegt.

5. Verfahren nach einem vorangehenden Anspruch, wobei der Schritt des Abscheidens von NiCoCrAIY ein Abscheiden der NiCoCrAIY-Schicht (16) und Verwendung eines Kathodenbogen-Abscheidungsprozesses aufweist.

6. Verfahren nach einem vorangehenden Anspruch, wobei der Schritt des Abscheidens von NiCoCrAIY ein Abscheiden von NiCoCrAIY-Material aufweist, das von etwa 4,0 bis 25 Gewichtsprozent Chrom, von etwa 2,0 bis 28 Gewichtsprozent Kobalt, von etwa 5,5 bis 15 Gewichtsprozent Aluminium, von etwa 0,1 bis 1,6 Gewichtsprozent Yttrium, bis zu etwa 2,0 Gewichtsprozent Hafnium, bis zu etwa 2,0 Gewichtsprozent Silicium, von etwa 3,0 bis 12 Gewichtsprozent Tantal, von etwa 1,0 bis 12 Gewichtsprozent Wolfram, von etwa 1,0 bis 10 Gewichtsprozent Rhenium, bis zu etwa 2,0 Gewichtsprozent Zirconium, bis zu etwa 4,0 Gewichtsprozent Niob, bis zu etwa 4,0 Gewichtsprozent Titan, von etwa 0,2 bis 6,0 Gewichtsprozent Molybdän, und Rest Nickel aufweist.

7. Verfahren nach einem der Anspruche 1 bis 5, wobei der Schritt des Abscheidens von NiCoCrAIY ein Abscheiden eines NiCoCrAIY-Materials aufweist, das von etwa 4,0 bis 18 Gewichtsprozent Chrom, von etwa 2,0 bis 24 Gewichtsprozent Kobalt, von etwa 5,5 bis 13,5 Gewichtsprozent Aluminium, von etwa 0,1 bis 0,8 Gewichtsprozent Yttrium, von etwa 0,001 bis 0,4 Gewichtsprozent Hafnium, von etwa 0,001 bis 0, 7 Gewichtsprozent Silicium, von etwa 3,0 bis 10 Gewichtsprozent Tantal, von etwa 1,0 bis 9,0 Gewichtsprozent Wolfram, von etwa 1,0 bis 5,0 Gewichtsprozent Rhenium, von etwa 0,001 bis 1,0 Gewichtsprozent Zirconium, von etwa 0,001 bis 2,0 Gewichtsprozent Niob, von etwa 0,001 bis 2,0 Gewichtsprozent Titan, von etwa 0,2 bis 4,0 Gewichtsprozent Molybdän, und Rest Nickel aufweist.

8. Verfahren nach einem vorangehenden Anspruch, wobei die Inertgas-Atmosphäre, in der das Substrat (10) wärmebehandelt wird, eine ArgonAtmosphäre ist.

9. Verfahren nach einem vorangehenden Anspruch, außerdem aufweisend ein Auftragen einer keramischen Deckschicht über der Bindungsschicht, die eine Dicke in dem Bereich von etwa 1,0 bis 50 mil (0,025 bis 1,27 mm) hat.

10. Verfahren nach einem der Ansprüche 1 bis 8, außerdem aufweisend ein Auftragen einer keramischen Deckschicht (20) über der Bindungsschicht, die eine Dicke in dem Bereich von etwa 3,0 bis 15 mil (0, 076 bis 0, 381 mm) hat.

11. Verfahren nach Anspruch 9 oder 10, wobei der Schritt des Auftragens der keramischen Deckschicht ein Auftragen einer Yttriumoxidstabilisierten Zirconiumdioxid-Deckschicht (20) aufweist.

12. Verfahren nach Anspruch 9 oder 10, wobei der Schritt des Auftragens der keramischen Deckschicht ein Auftragen einer Pyrochlor-Deckschicht (20) auf der Basis von Zirconiumdioxid aufweist.

13. Verfahren nach Anspruch 9 oder 10, wobei der Schritt des Auftragens der keramischen Deckschicht ein Auftragen von Zirconiumdioxid, das mit 5,0 bis 60 Mol% Gadoliniumoxid stabilisiert ist, aufweist.

14. Verfahren nach einem der Ansprüche 9 bis 13, wobei der Schritt des Auftragens der keramischen Deckschicht ein Auftragen der Deckschicht (20) unter Verwendung einer EB-PVD-Technik und ein dadurch Bilden der Deckschicht (20) mit einer Mikrostruktur mit säulenförmigen Körnern, in der säulenförmige Körner im Wesentlichen senkrecht zu der Substratoberfläche (12) ausgerichtet sind und sich von der Bindungsschicht nach außen erstrecken, aufweist.

15. Turbinenmaschinen-Bauteil aufweisend:
ein Substrat (10), das aus einer Superlegierung auf Nickelbasis hergestellt ist; und
eine auf eine Oberfläche (12) des Substrats (10) aufgetragene platinmodifizierte NiCoCrAIY-Bindungsschicht, die eine dreidimensional ineinandergreifende Zwei-Phasen-Mikrostruktur mit Korngrößen von 0,5 bis 30 µm hat und von etwa 5,0 bis 70 Gewichtsprozent Platin enthält, die nach dem Verfahren nach einem der Ansprüche 1 bis 8 hergestellt wurde.

16. Turbinenmaschinen-Bauteil nach Anspruch 15, wobei die Bindungsschicht eine Dicke in dem Bereich von 1,0 bis 5,0 Mil (0,025 bis 0,127 mm) hat.

17. Turbinenmaschinen-Bauteil nach Anspruch 15 oder 16, außerdem aufweisend eine keramische Deckschicht (20) und eine Schicht (18) aus Aluminiumoxid-Belag zwischen der keramischen Deckschicht (20) und der Bindungsschicht, wobei die Bindungsschicht die Haftung des Aluminiumoxid-Belags (18) verbessert.

18. Turbinenmaschinen-Bauteil nach Anspruch 17, wobei die keramische Deckschicht (20) ein Yttriumoxid-stabilisiertes Zirconiumdioxid aufweist.

19. Turbinenmaschinen-Bauteil nach Anspruch 17, wobei die keramische Deckschicht (20) eine Pyrochlor-Deckschicht auf Zirconiumdioxid-Basis aufweist.

20. Turbinenmaschinen-Bauteil nach Anspruch 17, wobei die keramische Deckschicht (20) ein mit 5 bis 60 Mol% Gadoliniumoxid stabilisiertes Zirconiumdioxid aufweist.

21. Turbinenmaschinen-Bauteil nach einem der Ansprüche 17 bis 20, wobei die keramische Deckschicht (20) eine Dicke in dem Bereich von 1,0 bis 50 Mil (0,025 bis 1,27 mm) und eine Mikrostruktur mit säulenförmigen Körnern hat, wobei säulenförmige Körner im Wesentlichen senkrecht zu der Oberfläche (12) des Substrats (10), sich von der Bindungsschicht und dem Aluminiumoxid-Belag (18) nach außen erstreckend, ausgerichtet sind.

22. Turbinenmaschinen-Bauteil nach Anspruch 21, wobei die Dicke in dem Bereich von 3,0 bis 15 Mil (0,076 bis 0,381 mm) ist.

23. Turbinenmaschinen-Bauteil nach einem der Ansprüche 15 bis 22, wobei die Bindungsschicht von etwa 10 bis etwa 60 Gewichtsprozent Platin enthält.

## Revendications

1. Procédé de formation d'un revêtement sur un substrat (10) comprenant les étapes consistant à :
se procurer un substrat (10) ;
déposer une couche (14) de platine sur une surface (12) dudit substrat (10) ; et
déposer une couche de NiCoCrAIY (16) sur ladite couche de platine ;
**caractérisé par** l'étape consistant à :
traiter thermiquement ledit substrat (10) avec lesdites couches déposées (14, 16) à une température dans la gamme d'environ 1200 à environ 2100 degrés Fahrenheit (649 °C-1149 °C) pendant une période de temps dans la gamme d'environ 2,D à 15 heures dans une atmosphère gazeuse inerte de manière à former une couche d'accrochage de NiCoCrAIY modifié au platine ayant une microstructure tridimensionnelle biphasique interconnectée avec des tailles de grains de 0,5 à 30 µm, ledit platine dans ladite couche d'accrochage étant présent dans une quantité d'environ 5,0 à 70 % en poids.

2. Procédé selon la revendication 1, dans lequel ladite étape d'obtention d'un substrat comprend l'obtention d'un substrat (10) constitué d'un alliage à base de nickel, et dans lequel ladite étape de dépôt d'une couche de platine (14) comprend le dépôt électrolytique de ladite couche de platine (14) sur ladite surface (12) du substrat.

3. Procédé selon la revendication 1 ou 2, dans lequel ladite étape de dépôt de platine comprend le dépôt d'une couche (14) de platine ayant une épaisseur dans la gamme de 0,01 à 1,0 mil (0,00025-0,025 mm).

4. Procédé selon l'une quelconque des revendications précédentes, dans lequel ledit platine dans ladite couche d'accrochage est présent dans une quantité d'environ 10 à 60 % en poids.

5. Procédé selon l'une quelconque des revendications précédentes, dans lequel ladite étape de dépôt de NiCoCrAIY comprend le dépôt de ladite couche de NiCoCrAIY (16) en utilisant un procédé de dépôt par arc cathodique.

6. Procédé selon l'une quelconque des revendications précédentes, dans lequel ladite étape de dépôt de NiCoCrAIY comprend le dépôt d'un matériau NiCoCrAIY comprenant environ 4,0 à 25% en poids de chrome, environ 2,0 à 28 % en poids de cobalt, environ 5,5 à à 15 % en poids d'aluminium, environ 0,1 à 1,6 % en poids d'yttrium, jusqu'à 2,0 % en poids environ de hafnium, jusqu'à 2,0 % en poids environ de silicium, environ 3,0 à 12 % en poids de tantale, environ 1,0 à 12 % en poids de tungstène, environ 1,0 à 10 % en poids de rhénium, jusqu'à 2,0 % en poids environ de zirconium, jusqu'à 4,0 % en poids environ de niobium, jusqu'à 4,0 % en poids environ de titane, environ 0,2 à 6,0 % en poids de molybdène, et du nickel pour le solde.

7. Procédé selon l'une quelconque des revendications 1 à 5, dans lequel ladite étape de dépôt de NiCOCrAIY comprend le dépôt d'un matériau NiCoCrAIY comprenant environ 4,0 à 18 % en poids de chrome, environ 2,0 à à 24 % en poids de cobalt, environ 5,5 à 13,5 % en poids d'aluminium, environ 0,1 à 0,8 % en poids d'yttrium, environ 0,001 à 0,4 % en poids de hafnium, environ 0,001 à 0,7 % en poids de silicium, environ 3,0 à 10 % en poids de tantale, environ 1,0 à 9,0 % en poids de tungstène, environ 1,0 à 5,0 % en poids de rhénium, environ 0,001 à 1,0 % en poids de zirconium, environ 0,001 à 2,0 % en poids de niobium, environ 0,001 à 2,0 % en poids de titane, environ 0,2 à 4,0 % en poids de molybdène, et du nickel pour le solde.

8. Procédé selon l'une quelconque des revendications précédentes, dans lequel ladite atmosphère gazeuse inerte dans laquelle ledit substrat (10) est traité thermiquement est une atmosphère d'argon.

9. Procédé selon l'une quelconque des revendications précédentes, comprenant en outre l'application par-dessus ladite couche d'accrochage d'une couche de finition céramique ayant une épaisseur dans la gamme d'environ 1,0 à 50 mils (0,025-1,27 mm).

10. Procédé selon l'une quelconque des revendications 1 à 8, comprenant en outre l'application par-dessus ladite couche d'accrochage d'une couche de finition céramique (20) ayant une épaisseur dans la gamme d'environ 3,0 à 15 mils (0,076-0,381 mm).

11. Procédé selon la revendication 9 ou 10, dans lequel ladite étape d'application d'une couche de finition céramique comprend l'application d'une couche de finition de zircone stabilisée à l'oxyde d'yttrium (20).

12. Procédé selon la revendication 9 ou 10, dans lequel ladite étape d'application d'une couche de finition céramique comprend l'application d'une couche de finition de pyrochlore à base de zircone (20).

13. Procédé selon la revendication 9 ou 10, dans lequel ladite étape d'application d'une couche de finition céramique comprend l'application d'une zircone stabilisée à l'oxyde de gadolinium à 5,0 à 60 % en moles,

14. Procédé selon l'une quelconque des revendications 9 à 13, dans lequel ladite étape d'application d'une couche de finition céramique comprend l'application de ladite couche de finition (20) en utilisant une technique EB-PVD et en formant ainsi ladite couche de finition (20) avec une microstructure à grains colonnaires dans laquelle les grains colonnaires sont orientés de façon sensiblement perpendiculaire à ladite surface (12) du substrat et s'étendent vers l'extérieur depuis la couche d'accrochage.

15. Composant de moteur à turbine comprenant :
un substrat (10) constitué d'un superalliage à base de nickel ; et
une couche d'accrochage de NiCoCrAlY modifié au platine appliquée à une surface (12) dudit substrat (10) ayant une microstructure tridimensionnelle biphasique interconnectée avec des tailles de grains de 0,5 à 30 µm et contenant environ 5,0 à 70 % en poids de platine, formée par le procédé de l'une quelconque des revendications 1 à 8.

16. Composant de moteur à turbine selon la revendication 15, dans lequel ladite couche d'accrochage a une épaisseur dans la gamme de 1,0 à 5,0 mils (0,025-0,127 mm).

17. Composant de moteur à turbine selon la revendication 15 ou 16, comprenant en outre une couche de finition céramique (20) et une couche (18) de calamine d'oxyde d'aluminium entre ladite couche de finition céramique (20) et ladite couche d'accrochage, ladite couche d'accrochage améliorant l'adhérence de ladite couche de calamine d'oxyde d'aluminium (18).

18. Composant de moteur à turbine selon la revendication 17, dans lequel ladite couche de finition céramique (20) comprend une zircone stabilisée à l'oxyde d'yttrium.

19. Composant de moteur à turbine selon la revendication 17, dans lequel ladite couche de finition céramique (20) comprend une couche de finition de pyrochlore à base de zircone.

20. Composant de moteur à turbine selon la revendication 17, dans lequel ladite couche de finition céramique (20) comprend une zircone stabilisée à l'oxyde de gadolinium à 5 à 60 en moles.

21. Composant de moteur à turbine selon l'une quelconque des revendications 17 à 20, dans lequel ladite couche de finition céramique (20) a une épaisseur dans la gamme de 1, 0 à 50 mils (0,025-1,27 mm) et une microstructure à grains colonnaires avec des grains colonnaires orientés de façon sensiblement perpendiculaire à la surface (12) du substrat (10) s'étendant vers l'extérieur depuis la couche d'accrochage et la croûte d'alumine (18).

22. Composant de moteur à turbine selon la revendication 21, dans lequel ladite épaisseur se situe dans la gamme de 3,0 à 15 mils (0,076-0,381 mm).

23. Composant de moteur à turbine selon l'une quelconque des revendications 15 à 22, dans lequel ladite couche d'accrochage contient environ 10 à environ 60 % en poids de platine.
